# EUROPEAN PATENT APPLICATION

(11) **EP 4 471 833 A1**
(43) Date of publication of application: **04.12.2024**
(21) Application number: 23747009.1
(22) Date of filing: 26.01.2023
(51) Int. Cl.: H01L 21/205, C30B 25/04, C30B 29/38

(54) **SEMICONDUCTOR SUBSTRATE MANUFACTURING METHOD AND MANUFACTURING DEVICE, AND CONTROL DEVICE**

(30) Priority: 27.01.2022 JP 2022011293
(71) Applicant: Kyocera Corporation, Kyoto-shi Kyoto 612-8501 (JP)
(72) Inventor: AOKI, Yuta, Kyoto-shi, Kyoto 612-8501 (JP); KAMIKAWA, Takeshi, Kyoto-shi, Kyoto 612-8501 (JP); KOBAYASHI, Toshihiro, Kyoto-shi, Kyoto 612-8501 (JP); YOSHIKAWA, Hiromichi, Kyoto-shi, Kyoto 612-8501 (JP)
(74) Representative: Viering, Jentschura & Partner mbB Patent- und Rechtsanwälte
(86) International application number: PCT/JP2023/002374
(87) International publication number: WO 2023/145799

(57) **Abstract**

A manufacturing method of a semiconductor substrate includes a step of growing a nitride semiconductor portion (8) from an upper surface of a base substrate (BS) exposed in an opening portion (KS) of a mask (6), a step of irradiating a mask portion (5) and the nitride semiconductor portion (8) being grown with first light (L1) having a wavelength absorbed by the nitride semiconductor portion at a growth temperature, a step of receiving second light (L2) from a semiconductor substrate (10), and a step of transitioning a growth condition of the nitride semiconductor portion (8) from a first condition to a second condition.

## Description

### TECHNICAL FIELD

The present disclosure relates to a manufacturing method and a manufacturing apparatus of a semiconductor substrate, and a control device.

### BACKGROUND OF INVENTION

Patent Document 1 discloses a technique for forming a GaN-based semiconductor layer on a GaN-based substrate or a heterogeneous substrate (for example, a sapphire substrate) by using an epitaxial lateral overgrowth (ELO) method.

### CITATION LIST

### PATENT LITERATURE

Patent Document 1: JP 2013-251304 A

### SUMMARY

A manufacturing method of a semiconductor substrate according to the present embodiment includes preparing a template substrate comprising a base substrate and a mask located on the base substrate being provided with a mask portion and an opening portion; growing a nitride semiconductor portion from the base substrate exposed in the opening portion; irradiating a semiconductor substrate comprising the template substrate and the nitride semiconductor portion being grown with first light having a wavelength absorbed by the nitride semiconductor portion at a growth temperature of the nitride semiconductor portion; receiving second light from the semiconductor substrate; and transitioning a growth condition of the nitride semiconductor portion from a first condition to a second condition.

### BRIEF DESCRIPTION OF THE DRAWINGS

FIG. 1 is a cross-sectional view illustrating the configuration of a semiconductor substrate according to the present embodiment.
FIG. 2 is a flowchart showing a manufacturing method of the semiconductor substrate of the present embodiment.
FIG. 3 is a cross-sectional view illustrating the manufacturing method of the semiconductor substrate of the present embodiment.
FIG. 4 is a graph showing temporal changes in a reflectance, which is a ratio of an intensity of second light to an intensity of first light, and a set temperature.
FIG. 5 is a graph showing temporal changes in the reflectance, which is the ratio of the intensity of the second light to the intensity of the first light, and a relative level.
FIG. 6 is a plan view illustrating an example of a mask.
FIG. 7 is a cross-sectional view illustrating a configuration example of a base substrate.
FIG. 8 is a schematic view illustrating the configuration of a manufacturing apparatus of the semiconductor substrate according to the present embodiment.
FIG. 9 is a cross-sectional view illustrating a manufacturing method of a semiconductor substrate according to a first example.
FIG. 10 is a cross-sectional view illustrating a manufacturing method of a semiconductor element according to a second example.
FIG. 11 is a cross-sectional view illustrating the manufacturing method of the semiconductor substrate of the present embodiment.

### DESCRIPTION OF EMBODIMENTS

### Semiconductor Substrate

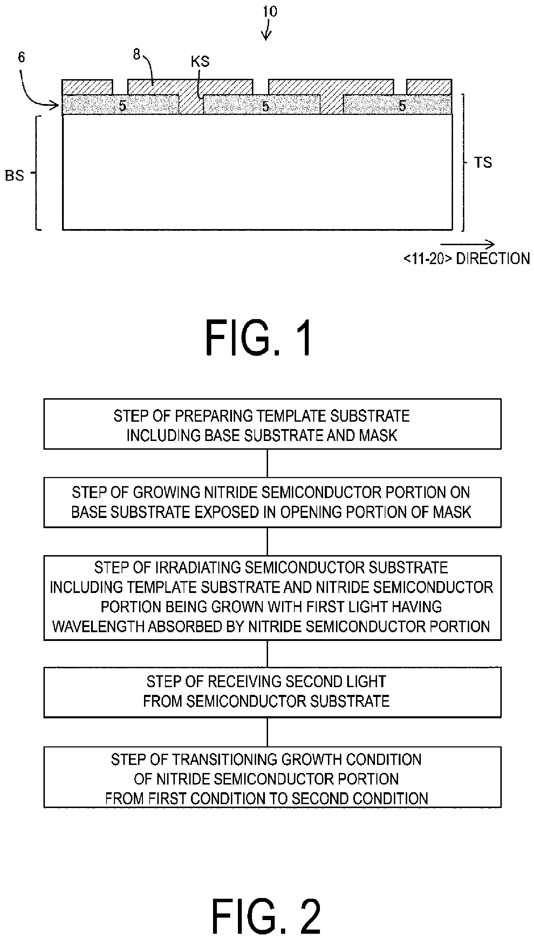

FIG. 1 is a cross-sectional view illustrating the configuration of a semiconductor substrate according to the present embodiment. As illustrated in FIG. 1, a semiconductor substrate 10 (semiconductor wafer) according to the present embodiment includes a base substrate BS, a mask (mask pattern) 6 formed on the base substrate and having an opening portion KS and a mask portion 5, and a nitride semiconductor portion 8 arranged from above the base substrate BS exposed in the opening portion KS to above the mask portion 5. The mask 5 may be a mask layer and the nitride semiconductor portion 8 may be a nitride semiconductor layer.

The nitride semiconductor portion 8 contains a nitride semiconductor as a main material. The nitride semiconductor may be expressed by, for example, AlxGayInzN (0 ≤ x ≤ 1; 0 ≤ y ≤ 1; 0 ≤ z ≤ 1; x + y + z = 1). Specific examples of the nitride semiconductor may include a GaN-based semiconductor, aluminum nitride (AlN), indium aluminum nitride (InAlN), and indium nitride (InN). The GaN-based semiconductor is a semiconductor containing gallium atoms (Ga) and nitrogen atoms (N). Typical examples of the GaN-based semiconductor may include GaN, AlGaN, AlGaInN, and InGaN.

The nitride semiconductor portion 8 may be of a doped type (for example, n-type including a donor) or a non-doped type. The semiconductor substrate means a substrate including a nitride semiconductor, and the base substrate BS may include a semiconductor (for example, a silicon-based semiconductor, SiC, or gallium oxide) other than a nitride semiconductor or a non-semiconductor (sapphire). The base substrate BS and the mask pattern 6 may be referred to as a template substrate TS.

The nitride semiconductor portion 8 can be formed by an epitaxial lateral overgrowth (ELO) method with the base substrate BS exposed from the opening portion K as a starting point. A thickness direction of the nitride semiconductor portion 8 may be a c-axis direction (<0001> direction). The opening portion KS has a longitudinal shape, and the width direction thereof may be an a-axis direction (<11-20> direction) of the nitride semiconductor portion 8. In the semiconductor substrate 10, a direction from the base substrate BS to the nitride semiconductor portion 8 is referred to as an "upward direction". Viewing an object with a line of sight parallel to a normal direction of the semiconductor substrate 10 (including viewing in a perspective manner) may be referred to as a "plan view".

### Manufacturing Method of Semiconductor Substrate

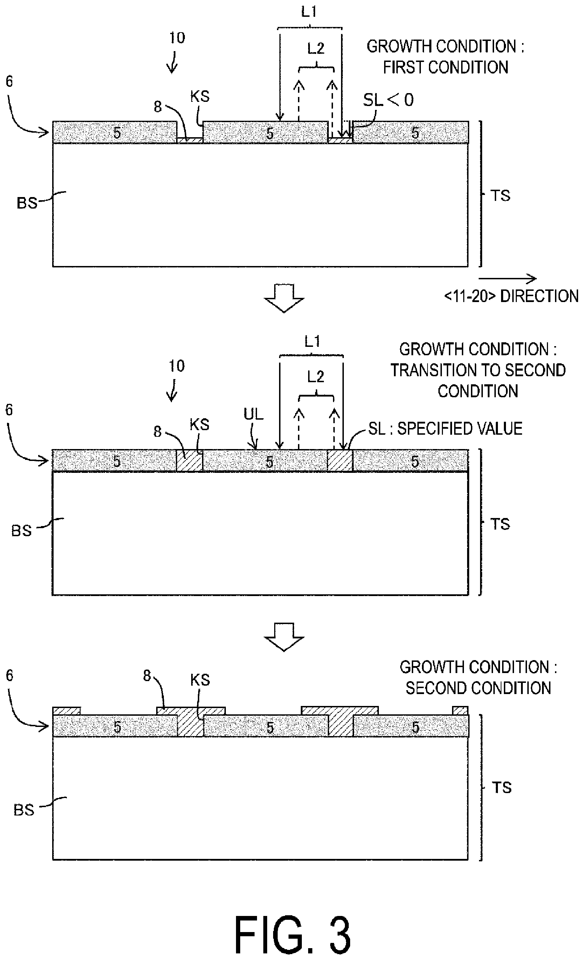

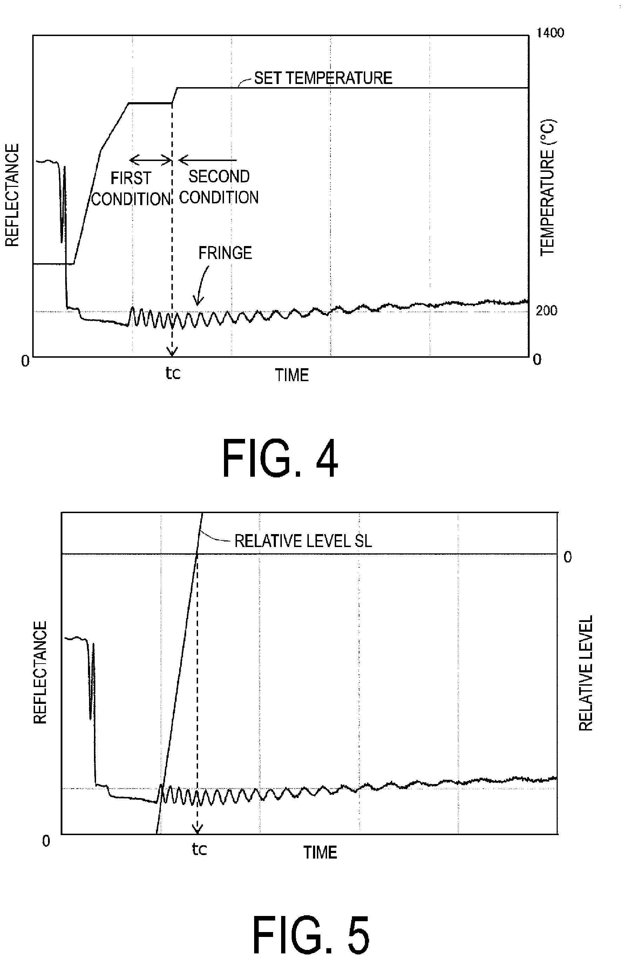

FIG. 2 is a flowchart showing a manufacturing method of the semiconductor substrate of the present embodiment. FIG. 3 is a cross-sectional view illustrating the manufacturing method of the semiconductor substrate of the present embodiment. FIG. 4 is a graph showing temporal changes in a reflectance, which is a ratio of an intensity of second light to an intensity of first light, and a set temperature.

As illustrated in FIGs. 2 to 4, the manufacturing method of the semiconductor substrate of the present embodiment performs a step of preparing the template substrate TS having the base substrate BS and the mask (mask pattern) 6 located on the base substrate BS and including the mask portion 5 and the opening portion KS, a step of growing the nitride semiconductor portion 8 from an upper surface (underlaying layer 4) of the base substrate BS exposed in the opening portion KS, a step of irradiating the semiconductor substrate 10 including the template substrate TS and the nitride semiconductor portion 8 being grown with first light L1 having a wavelength absorbed by the nitride semiconductor portion 8 at a growth temperature of the nitride semiconductor portion 8, a step of receiving second light L2 from the semiconductor substrate 10, and a step of performing a transition of a growth condition of the nitride semiconductor portion 8 (transition from a first condition to a second condition).

The first light L1 illustrated in FIG. 3 or the like may be emitted to the nitride semiconductor portion 8 and the mask portion 5. The second light L2 may include the first light L1 reflected by an upper surface of the nitride semiconductor portion 8 and the first light L1 reflected by an upper surface of the mask portion 5, and the transition of the growth condition from the first condition to the second condition may be started using the second light L2.

When a thickness direction of the mask portion 5 is a vertical direction and a width direction of the mask portion 5 is a lateral direction, the first condition may be a condition that gives priority to vertical growth (growth in the c-axis direction) of the nitride semiconductor portion 8, and the second condition may be a condition that gives priority to lateral growth (growth in the a-axis direction) of the nitride semiconductor portion 8. The wavelength of the first light L1 may be included in a wavelength range of 395 to 415 nm.

A relative level SL of the nitride semiconductor portion 8 with respect to an upper surface level UL of the mask portion 5 may be detected in time series using the intensity of the second light L2, and the transition of the growth condition may be started at the timing when the relative level SL reaches a specified value.

For example, the transition of the growth condition to the second condition may be started at a timing tc when the relative level SL is zero after a period in which the growth condition is the first condition and the relative level SL is negative (period in which the thickness of the nitride semiconductor portion 8 is less than the thickness of the mask portion 5) has elapsed after the start of the growth of the nitride semiconductor portion 8, and the nitride semiconductor portion 8 may be grown under the second condition after the transition. In this case, the specified value is 0. The transition may be started immediately after the timing when the relative level SL is zero. In this case, the specified value is a positive value.

A reflectance that is the ratio of an intensity of the second light L2 to an intensity of the first light L1 may be acquired in time series. In this case, the reflectance may vary periodically (appearance of fringes). The intensity of the first light L1 may be set to a fixed value, and the intensity (reflected light intensity) of the second light L2 may be acquired in time series. In this case, the intensity (reflected light intensity) of the second light L2 varies periodically.

FIG. 5 is a graph showing temporal changes in the reflectance, which is the ratio of the intensity of the second light to the intensity of the first light, and the relative level. As illustrated in FIG. 5, the number of cycles obtained in time series may correspond to the relative level SL. The amount of increase in the relative level SL per cycle may be a value corresponding to the wavelength of the first light L1 and the optical characteristics of the mask portion 5 and the nitride semiconductor portion 8. The detection timing of a predetermined number of cycles may be set as the timing tc when the relative level SL reaches the specified value (that is, the timing when the transition of the growth condition is started). The predetermined number in this case may be an integer, but is not limited to an integer.

In the ELO method, the transition timing from initial growth (for example, vertical growth) to growth under different growth conditions (for example, lateral growth) is important. When the transition timing is controlled by the film formation time, since the transition timing is too early or too late due to variations in a film formation rate caused by an opening width, characteristics of a manufacturing apparatus, and the like, a manufacturing yield may be reduced. The manufacturing yield is, for example, a rate at which a nitride semiconductor portion satisfying conformity conditions regarding a dislocation density (defect density), an aspect ratio, and the like is manufactured.

In the present embodiment, by measuring the interference between light reflected by the surface of the nitride semiconductor portion 8 being grown and light reflected from the mask portions 5 as a fringe (shape of temporal change in physical quantity such as reflectance) by using light having a wavelength (for example, 405 nm) absorbed by the nitride semiconductor portion 8 at the growth temperature, the growth state in the height direction (c-axis direction) can be monitored regardless of the internal structure of the base substrate BS. When light having a wavelength (for example, 633 nm or 950 nm) that passes through a nitride semiconductor at the growth temperature is used, interpreting a fringe (extracting components that contribute to film thickness detection) is difficult due to the influence of the structure of the base substrate.

The inventors have found that when the nitride semiconductor portion 8 (for example, a GaN crystal) is grown on the template substrate TS including the mask 6 (mask pattern), a fringe occurs at a wavelength of 405 nm, which is not seen when a nitride semiconductor is grown on a flat substrate including no mask pattern. Since light with a wavelength of 405 nm is absorbed by a nitride semiconductor (for example, GaN) at the growth temperature of the nitride semiconductor portion 8 (high temperature of 1000°C or higher), no fringe is visible on the flat substrate; however, when the template substrate TS having the mask 6 (for example, a mask pattern including a silicon nitride film as the mask portion 5) is used, the interference of light reflected by the surface of the nitride semiconductor portion 8 and the surface of the mask portion 5 can be measured as a fringe.

The ratio of the intensity of reflected light to the intensity of incident light on the upper surface of the nitride semiconductor portion 8 (reflectance of the nitride semiconductor portion) may be greater than the ratio of the intensity of the reflected light to the intensity of incident light on the upper surface of the mask portion 5 (reflectance of the mask portion).

An absorption coefficient of the first light L1 at the growth temperature of the nitride semiconductor portion 8 may be 10 times or more an absorption coefficient of the first light L1 at room temperature. A band gap of the nitride semiconductor portion 8 at the growth temperature may be less than a band gap (3.4 eV in the case of GaN) of the nitride semiconductor portion 8 at room temperature. The wavelength of the first light L1 may be set in accordance with the band gap of the nitride semiconductor portion 8 at the growth temperature. The first light L1 may be a laser beam.

When the absorption coefficient of the first light L1 at the growth temperature of the nitride semiconductor portion 8 is K [m⁻¹] and the thickness of the mask portion 5 is D [m], K > 1/D may be satisfied.

The nitride semiconductor portion 8 includes a GaN-based semiconductor, the growth condition includes a growth temperature, and regarding the growth temperature, a first temperature as the first condition is preferably a temperature suitable for the vertical growth and may be lower than a second temperature as the second condition. The growth condition may include a flow rate of a raw material gas containing gallium, and regarding the flow rate of the raw material gas, a first flow rate as the first condition may be less than a second flow rate as the second condition.

When the a-axis direction of the nitride semiconductor portion 8 is the width direction of the mask portion 5 or the opening portion KS, a width of the mask portion 5 may be 20 µm or more. The ratio of the thickness of the mask portion 5 to the width of the opening portion KS may be 3.0 or less.

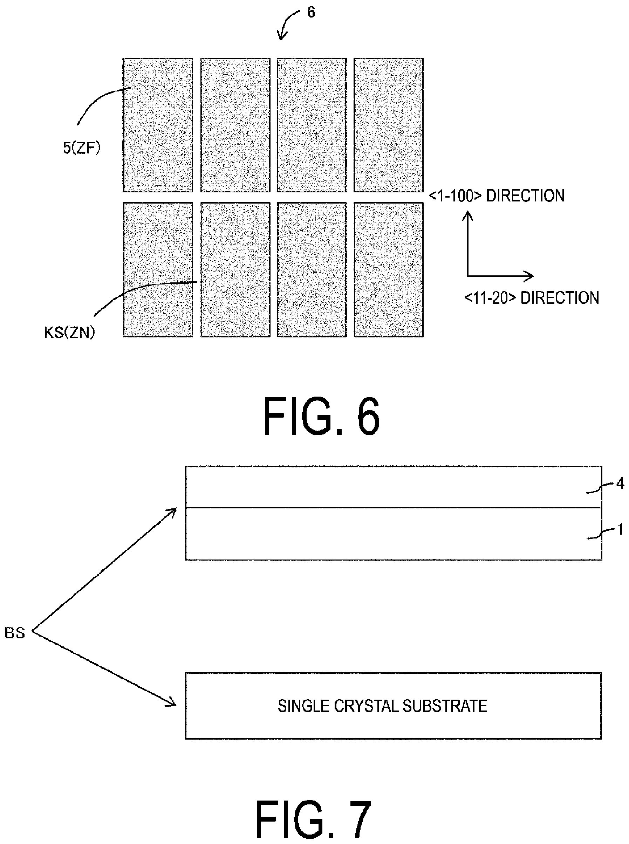

FIG. 6 is a plan view illustrating an example of the mask. The opening portion KS of the mask 6 (mask pattern) may have a function of a growth start opening that exposes the upper surface of the base substrate and starts the growth of the nitride semiconductor portion 8, and the mask portion 5 may have a function of a selective growth mask that grows the nitride semiconductor portion 8 in the lateral direction. The opening portion KS is a portion (non-formation portion) where the mask portion 5 in the mask pattern 6 is not present, and may not be surrounded by the mask portion 5.

As the mask 6, an inorganic film ZF (inorganic insulating film) such as a silicon oxide (SiOx) film, a silicon nitride (SiNx) film, a silicon oxynitride (SiON) film, and a titanium nitride (TiNx) film may be used. The opening portion KS has a longitudinal shape, and a plurality of opening portions KS may be periodically arranged in the <11-20> direction (a-axis direction) of the nitride semiconductor portion 8. The width of the opening portion KS may be about 0.2 µm to 20 µm. As the width of the opening portion KS is smaller, the number of threading dislocations propagating from the opening portion KS to the nitride semiconductor portion 8 is reduced. The nitride semiconductor portion 8 is easily peeled in a post-process to be described below. For the mask 6, a layered film including the above materials (for example, at least two of silicon oxide, silicon nitride, and silicon oxynitride) may also be used.

In the mask 6 (mask pattern), a plurality of longitudinal inorganic films ZF each functioning as the mask portion 5 may be arranged in the <11-20> direction (a-axis direction) of the nitride semiconductor portion 8 with a plurality of gaps ZN each functioning as the opening portion KS. The plurality of longitudinal inorganic films ZF may be arranged in the <11-20> direction (a-axis direction) and also in the <1-100> direction (m-axis direction).

FIG. 7 is a cross-sectional view illustrating a configuration example of the base substrate. The base substrate BS may include a main substrate 1 that is a heterogeneous substrate having a different lattice constant from the nitride semiconductor portion 8. The nitride semiconductor portion 8 may include a GaN-based semiconductor, and the main substrate 1, which is a heterogeneous substrate, may be a silicon substrate. Examples of the heterogeneous substrate include a sapphire (Al₂O₃) substrate and a silicon carbide (SiC) substrate in addition to a silicon substrate. The plane orientation of the main substrate 1 is, for example, the (111) plane of the silicon substrate, the (0001) plane of the sapphire substrate, or the 6H-SiC (0001) or 4H-SiC (0001) plane of the SiC substrate. These are merely examples, and any substrate and any plane orientation may be used as long as the nitride semiconductor portion 8 can be grown by the ELO method.

The base substrate BS may include the main substrate 1 and an underlying portion 4 on the main substrate 1, and the nitride semiconductor portion 8 may be grown from an upper surface of the underlying portion 4 exposed in the opening portion KS. The underlying portion 4 may include a GaN-based semiconductor. The underlying portion 4 may include a seed portion and/or a buffer portion. As the seed portion, a GaN-based semiconductor can be used. As the buffer portion, a GaN-based semiconductor, AlN, SiC, or the like can be used. The base substrate BS may be formed of a freestanding single crystal substrate (for example, a wafer cut out from a bulk crystal) of GaN, SiC, or the like, and the mask 6 may be disposed on the single crystal substrate.

### Manufacturing Apparatus of Semiconductor Substrate

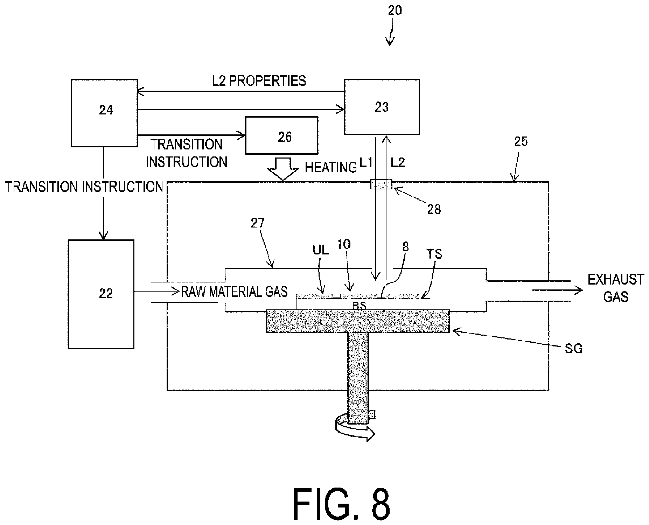

FIG. 8 is a schematic view illustrating the configuration of a manufacturing apparatus of the semiconductor substrate according to the present embodiment. As illustrated in FIG. 8, a manufacturing apparatus 20 of the semiconductor substrate includes the base substrate BS, a stage 21, on which the template substrate TS is placed, located on the base substrate BS and having a mask pattern including a mask portion and an opening portion, a raw material supply device 22 that supplies a raw material causing the nitride semiconductor portion 8 to be grown on the template substrate TS, an optical device 23 that irradiates the semiconductor substrate 10 including the template substrate TS and the nitride semiconductor portion being grown with the first light L1 having a wavelength absorbed by the nitride semiconductor portion 8 at the growth temperature of the nitride semiconductor portion 8 and receives the second light L2 from the semiconductor substrate 10, and a control device 24 that controls the raw material supply device 22 so that the growth condition of the nitride semiconductor portion 8 transitions from the first condition (for example, first flow rate) to the second condition (for example, second flow rate > first flow rate). The control device 24 may perform wired communication and/or wireless communication with the optical device 23.

The manufacturing apparatus 20 of the semiconductor substrate may be provided with a chamber 25 including the stage SG, a flow channel 27 passing through the chamber 25, and a heating device 26 for heating the chamber 25, and the semiconductor substrate 10 may be disposed in the flow channel 27. The control device 22 may instruct the heating device 26 to transition from the first condition (first temperature) to the second condition (second temperature > first temperature) by using the intensity of the second light L2. The optical device 23 may be located outside the chamber 25. The chamber 25 may be provided with a window 28 through which the first light L1 and the second light L2 pass.

The stage 21 may perform a rotation operation (with an axis in the normal direction of the template substrate TS as a rotation axis). In FIG. 8, the raw material supply device 22 causes a raw material gas to flow laterally (in a direction parallel to the upper surface of the template substrate) in the flow channel 27 under the first and second conditions to perform lateral exhaust; however, the present disclosure is not limited thereto. The raw material gas can also be caused to flow in a vertical direction (normal direction of the template substrate TS) under the first and second conditions.

The control device 24 may detect the relative level of the upper surface of the nitride semiconductor portion 8 with respect to the upper surface level UL of the mask portion 5 in time series by using the intensity of the second light L2, and instruct the raw material supply device 22 to transition from the first condition (for example, first flow rate) to the second condition (for example, second flow rate > first flow rate) at a timing when the relative level reaches a specified value (see tc in FIG. 5) or instruct the heating device 26 to transition from the first condition (first temperature) to the second condition (second temperature > first temperature) at this timing.

The control device 24 may be configured to control at least one of the raw material supply device 22 and the heating device 26 by executing a program stored in a built-in memory, a communicable communication device, or an accessible network, and the present embodiment also includes the program and a recording medium storing the program therein.

### First Example

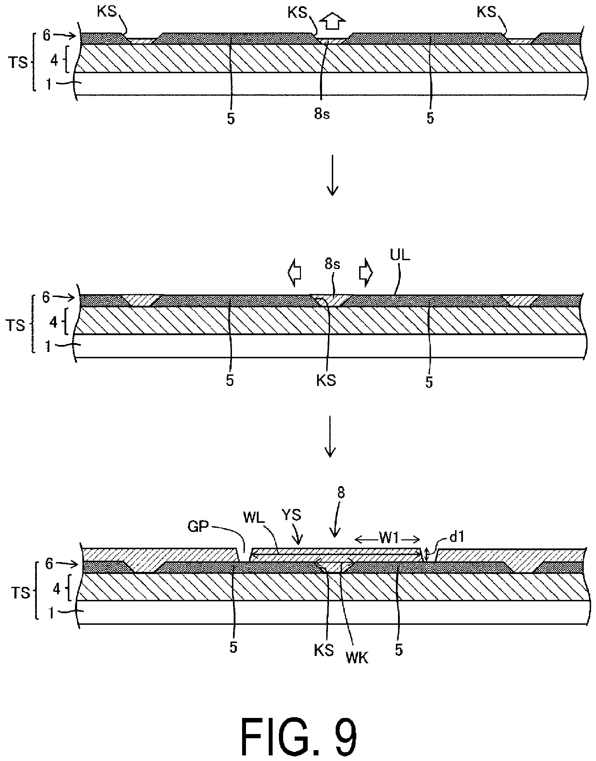

FIG. 9 is a cross-sectional view illustrating a manufacturing method of a semiconductor substrate according to a first example. In FIG. 9, the underlying portion 4 including a nitride semiconductor is formed on the main substrate 1, and the mask pattern 6 including a plurality of stripe-shaped mask portions 5 is provided on the underlying portion 4. The mask 5 portion is made of a silicon nitride film having a thickness of 100 nm and a width of 52 µm, and has a vertical direction in the m-axis direction of the nitride semiconductor portion 8. The pitch of the stripes of the mask portion 5 is 55 µm.

A resist stripe pattern is formed by photolithography on the base substrate BS on which the nitride semiconductor film is formed as the underlying portion 4. A silicon nitride film having a thickness of 100 nm is formed on the entire surface by sputtering. The silicon nitride film is patterned by a lift-off method to form the mask pattern 6 (stripe pattern). The nitride semiconductor portion 8 including an initial growth portion 8s is grown on the mask pattern 6 by metal-organic chemical vapor deposition (MOCVD) using trimethylgallium (TMG) and ammonia NH₃ (ELO method).

In FIG. 9, the initial growth portion 8s is formed above the underlying portion 4 exposed in the opening portion KS. The growth condition is the first condition. The transition of the growth condition (from the first condition to the second condition) is started at a timing immediately before an edge of the initial growth portion 8s rides on the upper surface of the mask portion 5 (at a stage in contact with the upper end of the side surface of the mask portion 5, relative level SL = 0) or immediately after the edge rides on the upper surface of the mask portion 5 (SL > 0). In some semiconductor elements (devices), the nitride semiconductor portion 8 may be thicker to some extent. In such a case, the nitride semiconductor portion 8 is easily formed thick by increasing the thickness of the initial growth portion 8s to which the first condition is applied. In such a case, the first condition may be transitioned to the second condition at a timing when the relative level SL is greater than 0 to some extent.

In the first example, a film thickness monitoring technique described in the embodiment was used, and the first condition (condition that gives priority to the vertical growth) was set as follows. Growth temperature (set temperature) : 1100°C (first temperature), growth pressure : 10 kPa, ammonia flow rate : 7.5 slm, and trimethylgallium flow rate : 3 sccm. The second condition (condition that gives priority to the lateral growth) was set as follows. Growth temperature (set temperature) : 1175°C (second temperature), growth pressure : 10 kPa, ammonia flow rate : 7.5 slm, and trimethylgallium flow rate : 11 sccm.

The initial growth portion 8s serves as a starting point of the lateral growth of the nitride semiconductor portion 8. The initial growth layer 8s can be formed to have a thickness of, for example, 30 nm to 1000 nm, 50 nm to 400 nm, or 70 nm to 350 nm. By performing the lateral growth from the state in which the initial growth portion 8s slightly protrudes from the mask portion 5, growth of the nitride semiconductor portion 8 in the c-axis direction (thickness direction) can be suppressed, the nitride semiconductor portion 8 can be laterally grown at a high speed and high crystallinity, and consumption of raw materials is also reduced. Thus, the nitride semiconductor portion 8 (crystalline body of the nitride semiconductor such as GaN) having a low number of defects can be formed in thin and wide manner at a low cost.

The nitride semiconductor portions 8 laterally grown in opposite directions from two adjacent opening portions KS do not make contact with (do not meet) each other on the mask portion 5 but have a gap GP, thereby making it possible to reduce an internal stress in the nitride semiconductor portion 8. Thus, cracks and defects (dislocations) occurring in the nitride semiconductor portion 8 can be reduced. This effect is particularly effective when the main substrate 1 is a heterogeneous substrate. The width of the gap GP can be 5 µm or less, 3 µm or less, or 2 µm or less.

In the nitride semiconductor portion 8, a portion located on the initial growth portion 8s serves as a dislocation inheritance portion in which a great number of threading dislocations occur, and a portion (wing portion) on the mask portion 5 serves as a low-defect portion YS where a threading dislocation density is 1/10 or less compared to the dislocation inheritance portion. The threading dislocation is a dislocation (defect) extending in the nitride semiconductor portion 8 in the c-axis direction (<0001> direction). The threading dislocation density of the low-defect portion YS can be, for example, 5 × 10⁶ [pieces/cm²] or less. As described below, when an active portion (active layer) including a light-emitting portion is formed above the nitride semiconductor portion 8, the light-emitting portion can be disposed above the low-defect portion YS (to overlap the low-defect portion YS in plan view).

Regarding the low-defect portion YS, the ratio (W1/d1) of a size W1 in the a-axis direction to a thickness d1 can be set to 2.0 or more, for example. Using the method of the first example makes it possible to set W1/d1 to 1.5 or more, 2.0 or more, 4.0 or more, 5.0 or more, 7.0 or more, or 10.0 or more. It can be seen that when W1/d1 is 1.5 or more, a step of dividing the nitride semiconductor portion 8 (for example, a step of dividing the nitride semiconductor portion 8 to have an m-plane cross section) is facilitated in a subsequent step. The internal stress in the nitride semiconductor portion 8 is reduced and the warpage of the semiconductor substrate 10 is reduced.

The aspect ratio of the nitride semiconductor portion 8 (ratio of a size in the X direction to the thickness = WL/d1) can be set to 3.5 or more, 5.0 or more, 6.0 or more, 8.0 or more, 10 or more, 15 or more, 20 or more, 30 or more, or 50 or more. Using the method of the first example makes it possible to set the ratio WL/WK of the size WL in the X direction of the nitride semiconductor portion 8 to a width WK of the opening portion KS to 3.5 or more, 5.0 or more, 6.0 or more, 8.0 or more, 10 or more, 15 or more, 20 or more, 30 or more, or 50 or more, and makes it possible to increase the ratio of the low-defect portion. The nitride semiconductor portion 8 (including the initial growth portion 8s) illustrated in FIG. 9 can be a nitride semiconductor crystal (for example, a GaN crystal, an AlGaN crystal, an InGaN crystal, or an InAlGaN crystal).

### Second Example

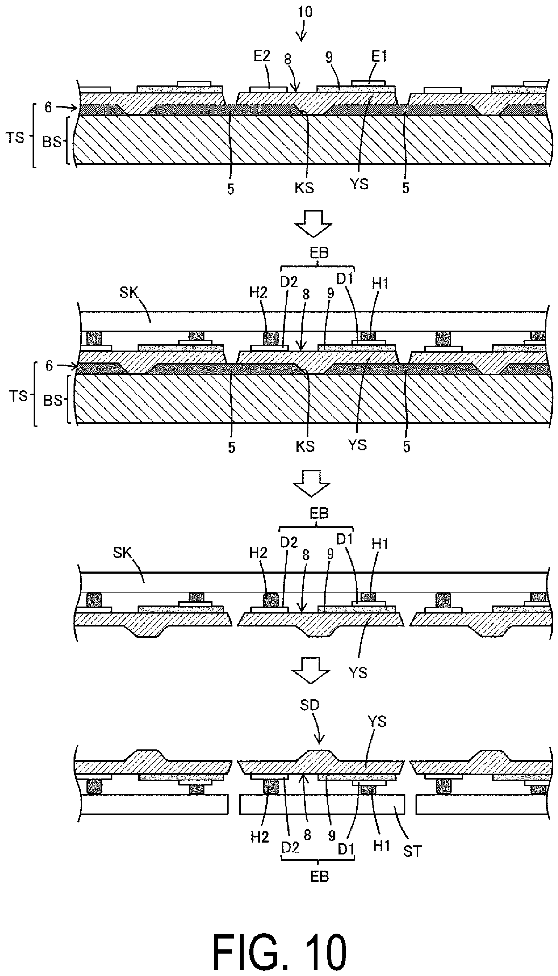

FIG. 10 is a cross-sectional view illustrating a manufacturing method of a semiconductor element according to a second example. In FIG. 10, the manufacturing method includes a step of, after preparing the above-described semiconductor substrate 10, forming a compound semiconductor portion 9 and electrodes D1 and D2 on the semiconductor substrate 10, a step of joining a layered body EB including the nitride semiconductor portion 8, the compound semiconductor portion 9, and the electrodes D1 and D2 to a support substrate SK via joining layers H1 and H2, a step of peeling off the base substrate BS, and a step of singulating the support substrate SK into a plurality of supports ST to form semiconductor elements SD holding the layered body EB on the supports ST. Before peeling off the base substrate BS, the mask 6 may be removed by wet etching or the like.

The nitride semiconductor portion 8 may be an n-type semiconductor crystal. The compound semiconductor portion 9 may include a GaN-based semiconductor. The compound semiconductor portion 9 may include an active portion (for example, an active layer having a quantum well structure or the like) and a p-type semiconductor portion, or may include an n-type semiconductor portion (for example, a regrowth layer or an n-type contact layer) under the active portion. When the active portion of the compound semiconductor portion 9 includes a light-emitting portion, the light-emitting portion can be disposed above the low-defect portion YS (to overlap the low-defect portion YS in plan view). Thus, the light emission efficiency can be increased.

The electrode D1 located above the low-defect portion YS may be an anode and the electrode D2 may be a cathode. The support substrate SK may have a conductive pad in contact with the joining layer H1 and a conductive pad in contact with the joining layer H2. The joining layers H1 and H2 may each be formed of a solder material. Before, during, or after joining to the support substrate SK, the layered body EB having a longitudinal shape may be divided into a plurality of pieces (by cutting in the short direction). In this case, the dividing step may be performed by cleaving the nitride semiconductor portion 8 and the compound semiconductor portion 9 (for example, m-plane cleavage in which a cleavage plane is an m-plane). In the case of forming a semiconductor laser element, end face coating (formation of a reflective mirror film) may be performed on the m-plane being the cleavage plane. Although the layered body EB is transferred from the base substrate BS to the support substrate SK in FIG. 10, the present disclosure is not limited thereto. The layered body EB may be transferred from the base substrate BS to a tape or the like one or more times.

Each semiconductor element SD may serve as a light-emitting diode (LED) element or a semiconductor laser element. The support ST may be a sub-mount substrate. The second example includes an electronic device (for example, an illumination device, a laser device, a display device, a measurement device, an information processing device, or the like) including the semiconductor element SD.

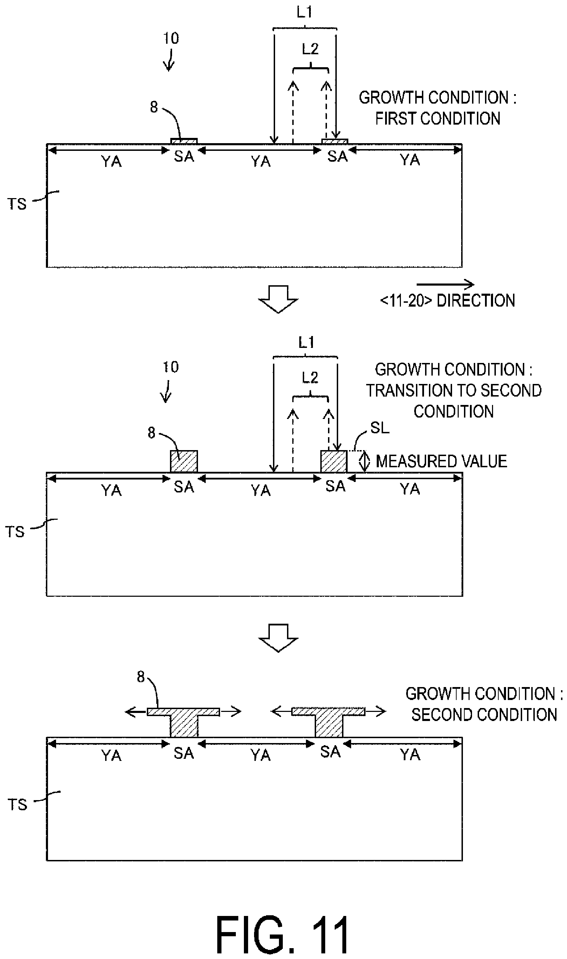

FIG. 11 is a cross-sectional view illustrating the manufacturing method of the semiconductor substrate of the present embodiment. The manufacturing method of the semiconductor substrate of the present embodiment performs a step of preparing the template substrate TS having a seed area SA and a growth suppression area YA on an upper surface side thereof, a step of growing the nitride semiconductor portion 8 from an upper surface of the seed area SA, a step of irradiating the semiconductor substrate 10 including the template substrate TS and the nitride semiconductor portion 8 being grown with the first light L1 having a wavelength absorbed by the nitride semiconductor portion 8 at the growth temperature of the nitride semiconductor portion 8, and a step of receiving the second light L2 from the semiconductor substrate 10, and a step of performing the transition of the growth condition of the nitride semiconductor portion 8 (transition from the first condition to the second condition).

The first light L1 in FIG. 11 may be emitted to the nitride semiconductor portion 8 and the growth suppression area YA. The second light L2 includes the first light L1 reflected by the upper surface of the nitride semiconductor portion 8 and the first light L1 reflected by the growth suppression area YA, and the transition of the growth condition from the first condition to the second condition may be started using the second light L2.

When the thickness direction of the template substrate TS is a vertical direction and the width direction of the growth suppression area YA is a lateral direction, the first condition may be a condition that gives priority to the vertical growth (growth in the c-axis direction) of the nitride semiconductor portion 8, and the second condition may be a condition that gives priority to the lateral growth (growth in the a-axis direction) of the nitride semiconductor portion 8. The wavelength of the first light L1 may be included in a wavelength range of 395 to 415 nm.

The relative level SL of the nitride semiconductor portion 8 with respect to a level YL of the growth suppression area YA may be detected in time series using the intensity of the second light L2, and the transition of the growth condition may be started at the timing when the relative level SL reaches a specified value.

For example, the transition of the growth condition to the second condition may be started at the timing when the relative level SL becomes the specified value (for example, 10 nm to 500 nm) after a period in which the growth condition is the first condition and the relative level SL is less than the specified value has elapsed after the start of the growth of the nitride semiconductor portion 8, and the nitride semiconductor portion 8 may be grown under the second condition after the transition.

The seed area SA may be made of a material on which the nitride semiconductor portion 8 is grown, and examples of the material include a GaN-based semiconductor, a nitride semiconductor such as aluminum nitride, and a crystalline material having a less lattice constant gap (with the nitride semiconductor portion 8) such as sapphire. The growth suppression area YA may be made of a material that suppresses the vertical growth (for example, growth in the c-axis direction) of the nitride semiconductor portion 8 and examples of the material include amorphous materials such as silicon nitride and silicon oxide, semiconductor materials such as SiC, polycrystalline materials, and metal materials.

### Supplementary Note

The foregoing disclosure has been presented for purposes of illustration and description, and not limitation. It is noted that many variations will be apparent to those skilled in the art based on these illustrations and descriptions, and these variations are included in the embodiments.

### REFERENCE SIGNS

1 Main substrate
4 Underlying layer
5 Mask portion
6 Mask (mask pattern)
8 Nitride semiconductor portion
10 Semiconductor substrate
20 Manufacturing apparatus of semiconductor substrate
22 Raw material supply device
23 Optical device
24 Control device
BS Base Substrate
TS Template substrate
KS Opening portion
YS Low-defect portion

## Claims

1. A manufacturing method of a semiconductor substrate, comprising:
preparing a template substrate comprising a base substrate and a mask located on the base substrate, the mask being provided with a mask portion and an opening portion;
growing a nitride semiconductor portion from the base substrate exposed in the opening portion;
irradiating a semiconductor substrate, comprising the template substrate and the nitride semiconductor portion being grown, with first light having a wavelength absorbed by the nitride semiconductor portion at a growth temperature of the nitride semiconductor portion;
receiving second light from the semiconductor substrate; and
transitioning a growth condition of the nitride semiconductor portion from a first condition to a second condition.

2. The manufacturing method of a semiconductor substrate according to claim 1, wherein
the first light is emitted to the nitride semiconductor portion and the mask portion.

3. The manufacturing method of a semiconductor substrate according to claim 1, wherein
the second light comprises light of the first light reflected by an upper surface of the nitride semiconductor portion and light of the first light reflected by an upper surface of the mask portion.

4. The manufacturing method of a semiconductor substrate according to any one of claims 1 to 3, wherein
the transitioning from the first condition to the second condition is performed using the second light.

5. The manufacturing method of a semiconductor substrate according to any one of claims 1 to 4, wherein,
when a thickness direction of the mask portion is a vertical direction and a width direction of the mask portion is a lateral direction, the first condition is a condition in which priority is given to vertical growth of the nitride semiconductor portion, while the second condition is a condition in which priority is given to lateral growth of the nitride semiconductor portion.

6. The manufacturing method of a semiconductor substrate according to any one of claims 1 to 5, wherein
a wavelength of the first light is within a wavelength range of 395 to 415 nm.

7. The manufacturing method of a semiconductor substrate according to any one of claims 1 to 6, wherein
a relative level of the upper surface of the nitride semiconductor portion with respect to an upper surface level of the mask portion is detected in time series using the second light.

8. The manufacturing method of a semiconductor substrate according to claim 7, wherein
the transitioning of the growth conditions is started at a timing when the relative level reaches a specified value.

9. The manufacturing method of a semiconductor substrate according to claim 7, wherein
the transitioning is performed at a timing when or after the relative level is zero.

10. The manufacturing method of a semiconductor substrate according to any one of claims 7 to 9, wherein
a reflectance being a ratio of an intensity of the second light to an intensity of the first light or an reflected light intensity being an intensity of the second light is acquired in time series.

11. The manufacturing method of a semiconductor substrate according to claim 10, wherein
the reflectance or the reflected light intensity varies periodically.

12. The manufacturing method of a semiconductor substrate according to any one of claims 1 to 11, wherein
an absorption coefficient of the first light at the growth temperature of the nitride semiconductor portion is 10 times or more an absorption coefficient of the first light at room temperature.

13. The manufacturing method of a semiconductor substrate according to any one of claims 1 to 12, wherein
when the absorption coefficient of the first light at the growth temperature of the nitride semiconductor portion is K [m⁻¹] and a thickness of the mask portion is D [m], K > 1/D is satisfied.

14. The manufacturing method of a semiconductor substrate according to any one of claims 1 to 13, wherein
the nitride semiconductor portion comprises a GaN-based semiconductor,
the growth condition comprises a growth temperature, and
regarding the growth temperature, a first temperature as the first condition is lower than a second temperature as the second condition.

15. The manufacturing method of a semiconductor substrate according to any one of claims 1 to 14, wherein
the nitride semiconductor portion comprises a GaN-based semiconductor,
the growth condition comprises a growth pressure, and
regarding the growth pressure, a first pressure as the first condition is higher than a second pressure as the second condition.

16. The manufacturing method of a semiconductor substrate according to any one of claims 1 to 15, wherein
a ratio of an intensity of reflected light to an intensity of incident light on the upper surface of the nitride semiconductor portion is greater than a ratio of an intensity of reflected light to an intensity of incident light on the upper surface of the mask portion.

17. The manufacturing method of a semiconductor substrate according to any one of claims 1 to 16, wherein
a width of the mask portion is 20 µm or more.

18. The manufacturing method of a semiconductor substrate according to any one of claims 1 to 17, wherein
a ratio of a thickness of the mask portion to a width of the opening portion is 3.0 or less.

19. The manufacturing method of a semiconductor substrate according to any one of claims 1 to 18, wherein
in the mask, a plurality of inorganic films having a longitudinal shape and each functioning as a mask portion are arranged in a <11-20> direction of the nitride semiconductor portion with a gap functioning as the opening portion.

20. The manufacturing method of a semiconductor substrate according to claim 19, wherein
the plurality of inorganic films having the longitudinal shape are arranged in the <11-20> direction and a <1-100> direction of the nitride semiconductor portion.

21. The manufacturing method of a semiconductor substrate according to any one of claims 1 to 20, wherein
the base substrate comprises a silicon substrate, and
the nitride semiconductor portion comprises a GaN-based semiconductor.

22. The manufacturing method of a semiconductor substrate according to any one of claims 1 to 21, wherein
the nitride semiconductor portion comprises a GaN-based semiconductor,
the growth condition comprises a flow rate of a raw material gas containing gallium, and
regarding the flow rate of the raw material gas, a first flow rate as the first condition is less than a second flow rate as the second condition.

23. A manufacturing apparatus of a semiconductor substrate, comprising:
a base substrate;
a stage, on which a template substrate is placed, located on the base substrate and comprising a mask comprising a mask portion and an opening portion;
a raw material supply device configured to supply a raw material causing a nitride semiconductor portion to be grown on the template substrate;
an optical device configured to irradiate a semiconductor substrate comprising the template substrate and the nitride semiconductor portion being grown with first light having a wavelength absorbed by the nitride semiconductor portion at a growth temperature of the nitride semiconductor portion, and to receive second light from the semiconductor substrate; and
a control device configured to control the raw material supply device so that a growth condition of the nitride semiconductor portion transitions from a first condition to a second condition.

24. The manufacturing apparatus of a semiconductor substrate according to claim 23, wherein
the control device instructs the raw material supply device to transition from the first condition to the second condition by using the second light.

25. The manufacturing apparatus of a semiconductor substrate according to claim 24, wherein
the control device detects a relative level of an upper surface of the nitride semiconductor portion with respect to an upper surface level of the mask portion in time series on the basis of a reflectance that is a ratio of an intensity of the second light to an intensity of the first light or the intensity of the second light, and instructs the raw material supply device to perform the transitioning when the relative level reaches a specified value.

26. A control device that is
communicable with a raw material supply device configured to supply a raw material causing a nitride semiconductor portion to be grown on a template substrate comprising a base substrate and a mask, and an optical device configured to irradiate a semiconductor substrate comprising the template substrate and the nitride semiconductor portion being grown with first light having a wavelength absorbed by the nitride semiconductor portion at a growth temperature of the nitride semiconductor portion and to receive second light from the semiconductor substrate, and
controls the raw material supply device so that a growth condition of the nitride semiconductor portion transitions from a first condition to a second condition.
